(19) Europäisches Patentamt
European Patent Office
Office européen des brevets

(11) Veröffentlichungsnummer: **0 476 519 A1**

(12) **EUROPÄISCHE PATENTANMELDUNG**

(21) Anmeldenummer: **91115458.1**

(22) Anmeldetag: **12.09.91**

(51) Int. Cl.5: **G03F 7/029**, G03F 7/032, G03F 7/11

(30) Priorität: **20.09.90 DE 4029795**

(43) Veröffentlichungstag der Anmeldung: **25.03.92 Patentblatt 92/13**

(84) Benannte Vertragsstaaten: **CH DE FR GB LI**

(71) Anmelder: **HOECHST AKTIENGESELLSCHAFT**
**Postfach 80 03 20**
**W-6230 Frankfurt am Main 80(DE)**

(72) Erfinder: **Frommeld, Hans-Dieter, Dr.**
**Simrockstrasse 7A**
**W-6200 Wiesbaden(DE)**

(54) **Photopolymerisierbares Gemisch und daraus hergestelltes Aufzeichnungsmaterial.**

(57) Es wird ein photopolymerisierbares Gemisch beschrieben, das ein polymeres Bindemittel, eine polymerisierbare Verbindung, ein Trichlormethyl-s-triazin und eine Verbindung der allgemeinen Formel II

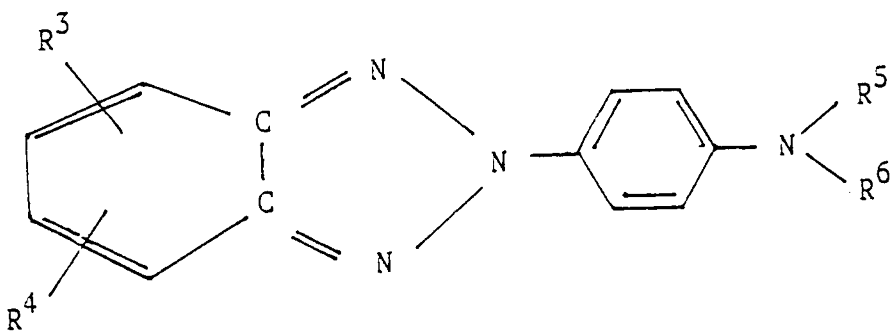

(II)

enthält, worin

$R^3$ und $R^4$ Wasserstoff- oder Halogenatome, Alkyl-, Alkoxy-, Alkoxycarbonyl- oder Arylreste oder gemeinsam einen anellierten Benzolring und

$R^5$ und $R^6$ Alkyl-, Aryl- oder Aralkylreste oder gemeinsam einen fünf- oder sechsgliedrigen heterocyclischen Ring bedeuten.

Das Gemisch ist zur Herstellung von trocken übertragbaren Photoresistschichten geeignet und zeichnet sich durch hohe Lichtempfindlichkeit bei gutem Bildkontrast aus.

EP 0 476 519 A1

Die Erfindung betrifft ein photopolymerisierbares Gemisch, das ein polymeres Bindemittel, eine radikalisch polymerisierbare Verbindung mit mindestens einer endständigen ethylenischen Doppelbindung und einem Siedepunkt oberhalb 100 °C bei Normaldruck sowie eine Photoinitiatorkombination enthält und das zur Herstellung von Aufzeichnungsmaterialien, insbesondere von Druckplatten und Photoresists, geeignet ist.

Aus der EP-A 138 187 ist eine Kombination eines Hexaarylbisimidazols mit einer heterocyclischen Verbindung, die mit einer oder mehreren p-Dialkylamino-phenylgruppen substituiert ist, als Photoinitiator bekannt. Das Gemisch weist eine hohe Lichtempfindlichkeit bei guter Lagerfähigkeit auf. Aus den EP-A 291 878 und 291 881 sind ähnliche Gemische bekannt, die Kombinationen aus substituierten 1,2,3-Triazolen und Hexaarylbisimidazolen oder N-Alkoxypyridiniumsalzen als Initiatorsysteme enthalten. Diese Gemische ergeben einen sichtbaren Farbkontrast nach dem Belichten.

In der EP-A 243 784 werden Initiatorkombinationen aus N-heterocyclischen Verbindungen, besonders Acridinverbindungen, und Trichlormethylgruppen enthaltenden Verbindungen beschrieben, die eine erhöhte Lichtempfindlichkeit ergeben.

Die bekannten Initiatorkombinationen ergeben Gemische, bei denen meist zumindest eine Eigenschaft, wie Lichtempfindlichkeit, Kontrast oder Lagerfähigkeit sehr gut ausgeprägt sind, jedoch andere dieser Eigenschaften nicht das gewünschte Maß erreichen.

Aufgabe der Erfindung war es, ein photopolymerisierbares Gemisch vorzuschlagen, das eine besonders günstige Kombination von Eigenschaften, wie hohe Lichtempfindlichkeit und starken Bildkontrast, aufweist.

Erfindungsgemäß wird ein photopolymerisierbares Gemisch vorgeschlagen, das als wesentliche Bestandteile

a) ein polymeres Bindemittel,

b) eine radikalisch polymerisierbare Verbindung mit mindestens einer endständigen ethylenischen Doppelbindung und einem Siedepunkt oberhalb 100 °C bei Normaldruck und

c) eine Trichlormethylverbindung der allgemeinen Formel I

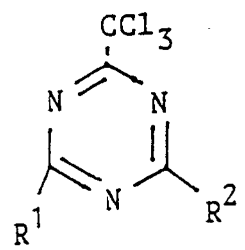

(I)

enthält, worin

$R^1$ und $R^2$ gleich oder verschieden sind und ggf. substituierte Alkyl-, Alkenyl- oder Arylreste oder Trichlormethylreste bedeuten.

Das erfindungsgemäße Gemisch ist dadurch gekennzeichnet, daß es als weiteren Photoinitiator eine Verbindung der allgemeinen Formel II

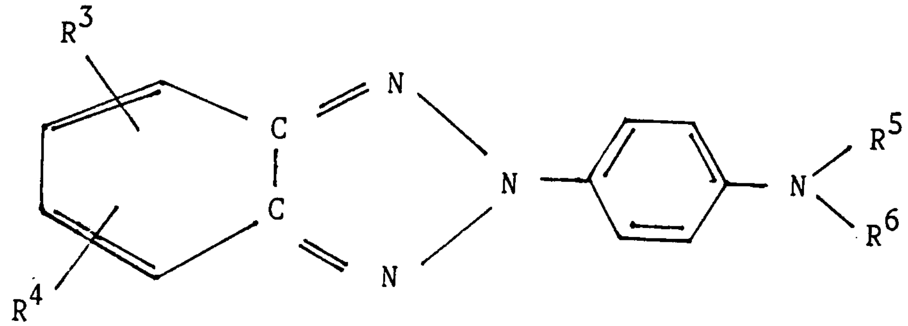

(II)

enthält, worin

$R^3$ und $R^4$ gleich oder verschieden sind und einzeln Wasserstoff- oder Halogenatome, Alkyl-, Alkoxy-, Alkoxycarbonyl- oder Arylreste oder gemeinsam einen anellierten Benzolring und

$R^5$ und $R^6$ untereinander gleiche oder verschiedene Alkyl-, Aryl- oder Aralkylreste oder gemeinsam einen fünf- oder sechsgliedrigen heterocyclischen Ring bedeuten.

Erfindungsgemäß wird weiterhin ein photopolymerisierbares Aufzeichnungsmaterial mit einem Schichtträger und einer photopolymerisierbaren Schicht vorgeschlagen, das dadurch gekennzeichnet ist, daß die Schicht aus dem vorstehend definierten Gemisch besteht.

Geeignete Verbindungen der Formel I sind in der EP-A 243 784 beschrieben. Von diesen Verbindungen werden diejenigen mit mindestens zwei Trichlormethylgruppen im Molekül bevorzugt. Wenn $R^1$ und/oder $R^2$ Alkylreste sind, haben sie im allgemeinen 1 bis 6, vorzugsweise 1 bis 3 Kohlenstoffatome; als Alkenylgruppen kommen solche mit 2 bis 6 Kohlenstoffatomen in Betracht. Die letzteren können bevorzugt durch aromatische Reste mit 1 oder 2 aromatischen Kernen substituiert sein, die selbst als Substituenten Halogenatome, Alkyl- oder Alkoxygruppen mit 1 bis 4 Kohlenstoffatomen tragen können. Als Arylreste kommen 1- bis 3-kernige, bevorzugt 1- oder 2-kernige Reste in Betracht, die ebenfalls Substituenten der vorstehend angegebenen Art oder Aralkenylsubstituenten tragen können. Beispiele für geeignete Reste $R^1$ und/oder $R^2$ sind Trichlormethylgruppen, Methylgruppen, Chlormethylgruppen, Methoxyethylgruppen, Vinyl-, Allyl-, Styryl-, $\alpha$-Chlor-styryl-, 2,6-Dimethylstyryl-, 4-Methoxystyryl-, 3-Bromstyryl-, 4-Methoxy-phenyl-, 4-Ethoxynaphthyl-(1)-, p-Biphenylyl-, 4-Styryl-phenyl- und 4-(p-Ethoxystyryl)-phenylgruppen. Das Gemisch enthält bevorzugt 0,05 bis 1 Gew.-% an Verbindungen der Formel I, bezogen auf seine nichtflüchtigen Bestandteile.

Geeignete Verbindungen der Formel II sind in der EP-A 291 878 beschrieben. Wenn $R^3$ und $R^4$ Alkyl- oder Alkoxygruppen sind oder solche enthalten, haben diese im allgemeinen 1 bis 6, bevorzugt 1 bis 3 Kohlenstoffatome; als Halogenatome werden Chlor oder Brom bevorzugt. Arylreste sind bevorzugt Phenylreste.

$R^5$ und $R^6$ können Alkylgruppen mit 1 bis 8, bevorzugt 1 bis 4 Kohlenstoffatomen, Arylgruppen mit 6 bis 10 Kohlenstoffatomen, wobei nicht mehr als einer dieser Reste eine Arylgruppe ist, oder Aralkylgruppen mit 7 bis 12 Kohlenstoffatomen sein. Wenn sie gemeinsam einen heterocyclischen Ring bedeuten, ist dieser im allgemeinen gesättigt und kann außer dem Stickstoffatom ein weiteres Heteroatom, das N, O oder S sein kann, enthalten. Bevorzugt sind $R^5$ und $R^6$ Alkylgruppen. Das Gemisch enthält bevorzugt 0,05 bis 0,5 Gew.-% an Verbindungen der Formel II. Es enthält im allgemeinen 0,1 bis 20, bevorzugt 0,3 bis 10 Gewichtsteile an Verbindungen der Formel I je 1 Gewichtsteil Verbindung der Formel II.

Bevorzugte Beispiele für Verbindungen der Formel II sind
2-(p-Dimethylaminophenyl)-benztriazol,
2-(p-Diethylaminophenyl)-chlor-benztriazol,
2-(p-Dipropylaminophenyl)-5-brom-benztriazol,
2-(p-Diethylaminophenyl)-5-brom-benztriazol,
2-(p-Dimethylaminophenyl)-5-methyl-benztriazol und
2-(p-Dimethylaminophenyl)-naphthtriazol.

Die erfindungsgemäßen Gemische enthalten polymerisierbare Verbindungen mit mindestens einer, vorzugsweise mindestens zwei endständigen ethylenischen Doppelbindungen. Als polymerisierbare Verbindungen werden im allgemeinen Ester der Acryl- oder Methacrylsäure mit mehrwertigen, vorzugsweise primären, Alkoholen verwendet. Beispiele für geeignete mehrwertige Alkohole sind Ethylenglykol, Propylenglykol, Butandiol-1,4, Butandiol-1,3, Diethylenglykol, Triethylenglykol, Polyethylen- oder Polypropylenglykole mit Molekulargewichten von 200 bis 1.000, Neopentylglykol, Glycerin, Trimethylolethan und -propan, Pentaerythrit, Bisphenol-A-Derivate sowie Umsetzungsprodukte dieser Verbindungen mit Ethylenoxid und/oder Propylenoxid. Mit Vorteil werden auch Urethangruppen enthaltende Bisacrylate und Bismethacrylate eingesetzt, die durch Umsetzung von 1 mol eines Diisocyanats mit 2 mol Hydroxyalkylacrylat oder -methacrylat erhalten werden. Das Diisocyanat kann auch ein oligomeres, durch Umsetzen eines Diols mit einem molaren Überschuß an monomerem Diisocyanat erhaltenes Produkt sein. Derartige und ähnliche Urethangruppen enthaltende Monomere sind in den DE-A 20 64 079, 28 22 190, 30 48 502 und 35 40 480 beschrieben.

Der Mengenanteil der Schicht an Monomeren beträgt im allgemeinen etwa 10 bis 75, vorzugsweise 20 bis 60 Gew.-%.

Als Bindemittel kann eine Vielzahl löslicher organischer Polymerisate Einsatz finden. Als Beispiele seien genannt: Polyamide, Polyvinylester, Polyvinylacetale, Polyvinylether, Epoxidharze, Polyacrylsäureester, Polymethacrylsäureester, Polyester, Alkydharze, Polyacrylamid, Polyvinylalkohol, Polyethylenoxid, Polydimethylacrylamid, Polyvinylpyrrolidon, Polyvinylmethylformamid, Poly-vinylmethylacetamid sowie Mischpolymerisate der Monomeren, die die aufgezählten Homopolymerisate bilden.

Ferner kommen als Bindemittel Naturstoffe oder umgewandelte Naturstoffe in Betracht, z.B. Gelatine und Celluloseether.

Mit Vorteil werden auch Bindemittel verwendet, die wasserunlöslich, aber in wäßrig-alkalischen Lösungen löslich oder mindestens quellbar sind. Derartige Bindemittel können z. B. die folgenden Gruppen enthalten: -COOH, $-PO_3H_2$, $-SO_3H$; $-SO_2NH-$, $-SO_2-NH-SO_2-$ und $-SO_2-NH-CO-$. Als Beispiele hierfür seien genannt: Maleinatharze, Polymerisate aus N-(p-Tolylsulfonyl)-carbaminsäure-$\beta$-methacryloyloxy-ethylester und Mischpolymerisate dieser und ähnlicher Monomerer mit anderen Monomeren sowie Vinylacetat/Crotonsäure- und Styrol/Maleinsäureanhydrid-Mischpolymerisate. Alkylmethacrylat/Methacrylsäure-Mischpolymerisate und Mischpolymerisate aus Methacrylsäure, höheren Alkyl-methacrylaten und Methylmethacrylat und/oder Styrol, Acrylnitril u.a., wie sie in den DE-A 20 64 080, 23 63 806 oder 34 27 519 beschrieben sind, werden bevorzugt. Mit Erfolg können auch die in der DE-A 38 05 706 beschriebenen Bindemittel auf Basis einer $\alpha,\beta$-ungesättigten Carbonsäure, eines Methacrylats, eines Acrylats und einer Verbindung mit einem aromatischen Substituenten eingesetzt werden.

Das Gemisch kann als übliche weitere Bestandteile Polymerisationsinhibitoren, sonstige Stabilisatoren, Wasserstoffdonatoren, Lichtempfindlichkeitsregler, Farbstoffe, Leukofarbstoffe, Photooxydationsmittel, z. B. Tribrommethylphenylsulfon, Pigmente, Weichmacher und thermisch aktivierbare Vernetzungsmittel enthalten.

Als aktinische Strahlung, gegenüber der das erfindungsgemäße Gemisch empfindlich ist, kommt jede elektromagnetische Strahlung in Betracht, deren Energie zur Auslösung einer Polymerisation ausreicht. Geeignet sind insbesondere sichtbares und ultraviolettes Licht, Röntgen- und Elektronenstrahlung. Auch Laserstrahlung im sichtbaren und UV-Bereich kann verwendet werden. Bevorzugt wird kurzwelliges sichtbares und nahes UV-Licht.

Als Schichtträger für mit dem erfindungsgemäßen Gemisch hergestellte Aufzeichnungsmaterialien sind beispielsweise Aluminium, Stahl, Zink, Kupfer, Siebe oder Kunststofffolien, z. B. aus Polyethylenterephthalat, geeignet. Die Trägeroberfläche kann chemisch oder mechanisch vorbehandelt werden, um die Haftung der Schicht richtig einzustellen.

Das erfindungsgemäße Gemisch findet bevorzugt Anwendung als trocken übertragbares Photoresistmaterial. Dazu kann es in bekannter Weise als vorgefertigte, übertragbare Trockenresistfolie auf das zu bearbeitende Werkstück, z. B. auf Leiterplatten-Basismaterial, aufgebracht werden. Im allgemeinen wird zur Herstellung des Trockenresistmaterials eine Lösung des Gemischs in einem Lösemittel auf einen geeigneten Schichtträger, z. B. eine Polyesterfolie, aufgebracht und getrocknet. Die Schichtdicke der Resistschicht kann etwa 10 bis 80, vorzugsweise 20 bis 60 µm betragen. Die freie Oberfläche der Schicht wird vorzugsweise mit einer weniger haftenden Deckfolie, z. B. aus Polyethylen oder Polypropylen, abgedeckt. Die Folien lassen sich mit in der Trockenresisttechnik üblichen Geräten verarbeiten. In einer handelsüblichen Laminiervorrichtung wird die Deckfolie abgezogen und die Photoresistschicht auf gebohrtes, verkupfertes Basismaterial laminiert. Die so präparierte Platte wird dann durch eine Vorlage belichtet und nach Abziehen der Trägerfolie in bekannter Weise entwickelt.

Als Entwickler sind organische Lösemittel, z. B. Trichlorethan, oder wäßrige, vorzugsweise wäßrig-alkalische Lösungen, z. B. von Alkaliphosphaten, -carbonaten oder -silikaten, geeignet, denen gegebenenfalls kleine Mengen an mit Wasser mischbaren, organischen Lösemitteln oder an Netzmitteln zugesetzt werden können.

Die erfindungsgemäßen Gemische lassen sich für die verschiedensten Anwendungsgebiete einsetzen. Mit besonderem Vorteil werden sie in Form eines Trockenresistfilms zur Herstellung von Reservagen, d. h. Ätzschutzschichten oder Galvanoreserven, auf metallischen Trägern, z. B. Kupfer, verwendet.

Bei Einsatz der erfindungsgemäßen Photoinitiatorkombination erhält man Photoresistschichten mit hoher Lichtempfindlichkeit, gutem Auflösungsvermögen und hohem sichtbarem Bildkontrast nach dem Belichten und nach dem Entwickeln.

Die folgenden Beispiele erläutern bevorzugte Ausführungsformen der Erfindung. Mengenverhältnisse und Prozentzahlen sind in Gewichtseinheiten zu verstehen, wenn nichts anderes angegeben ist. Die Mengen an Bestandteilen sind in der Regel in Gewichtsteilen (Gt) angegeben. Das Zeichen (V) hinter einer Beispielsvariante gibt an, daß es sich um ein Vergleichsbeispiel handelt.

## Beispiel 1

Es wurden Beschichtungslösungen hergestellt aus:

| | |
|---|---|
| 60 Gt | eines Polymerisats aus Methacrylsäure, Methylmethacrylat, Styrol und Butylacrylat (21:42:10:27), |
| 20 Gt | des Triacrylats von ethoxyliertem Trimethylolpropan, |
| 20 Gt | des Umsetzungsprodukts von 1 mol 2,2-Bis-(p-hydroxyphenyl)-propan-bis-(2,3-epoxypropylether) und 2 mol Acrylsäure, |
| 0,5 Gt | Leukokristallviolett und |
| 0,5 Gt | Viktoriareinblau FGA (C.I. Basic Blue 81) in |
| 135 Gt | Butanon und |
| 80 Gt | Ethanol. |

In jeder der so erhaltenen Stammlösungen wurde einer der folgenden Initiatorzusätze gelöst:

| | | |
|---|---|---|
| A (V) | 0,1 Gt | 2-(p-Dimethylaminophenyl)-5-brom-benztriazol, |
| | 1 Gt | N-Methoxy-2-picolinium-tosylat, |
| B (V) | 0,1 Gt | 2-(p-Dimethylaminophenyl)-5-brom-benztriazol, |
| | 1 Gt | 2,2'-Bis-(o-chlorphenyl)-4,4',5,5'-tetraphenyl-bisimidazol, |
| C | 0,1 Gt | 2-(p-Dimethylaminophenyl)-5-brom-benztriazol, |
| | 0,8 Gt | 2,2'-Bis-(o-chlorphenyl)-4,4',5,5'-tetraphenyl-bisimidazol, |
| | 0,2 Gt | 2-Methyl-4,6-bis-trichlormethyl-s-triazin, |
| D | 0,1 Gt | 2-(p-Dimethylaminophenyl)-5-brom-benztriazol, |
| | 0,5 Gt | 2,2'-Bis-(o-chlorphenyl)-4,4',5,5'-tetraphenyl-bisimidazol, |
| | 0,5 Gt | 2-Methyl-4,6-bis-trichlormethyl-s-triazin, |

| | | |
|---|---|---|
| **E** | **0,1 Gt** | **2-(p-Dimethylaminophenyl)-5-brom-benztriazol,** |
| | **1,0 Gt** | **2-Methyl-4,6-bis-trichlormethyl-s-triazin,** |
| **F** | **0,1 Gt** | **2-(p-Dimethylaminophenyl)-5-brom-benztriazol,** |
| | **1,0 Gt** | **2-p-Biphenylyl-4,6-bis-trichlormethyl-s-triazin.** |

Die Lösungen wurden auf biaxial verstreckte und thermofixierte Polyethylenterephthalatfolien von 25 µm Stärke so aufgebracht, daß nach dem Trocknen bei 100 °C jeweils ein Schichtgewicht von 31 $g/m^2$ erhalten wurde.

Um die Trockenresistschichten vor Verschmutzung durch Staub und Beschädigungen zu schützen, wurden sie mit einer 23 µm starken Deckfolie aus Polyethylen kaschiert. Danach können sie aufgerollt und über einen längeren Zeitraum unter Lichtausschluß gelagert werden.

Zur Bestimmung der Lichtempfindlichkeit wurden Proben der erhaltenen Trockenresistfolien in einer handelsüblichen Laminiervorrichtung bei 115 °C auf mit 35 µm starker Kupferfolie kaschierte Phenoplast-Schichtstoffplatten laminiert und mittels einer 5-kW-Metallhalogenidlampe im Abstand von 110 cm zwischen Lampe und Vakuumkopierrahmen 7 Sekunden belichtet. Als Vorlage diente ein 13-stufiger Belichtungskeil mit Dichteinkrementen von 0,15. Nach der Belichtung wurden die Polyesterfolien abgezogen und die Schichten mit 1 %iger Natriumcarbonatlösung in einem Sprühentwicklungsgerät innerhalb 60 s entwickelt. Je lichtempfindlicher das photopolymerisierbare Gemisch ist, desto mehr Stufen werden gehärtet und bleiben auf dem Kupfer stehen.

Zur Bestimmung des Belichtungskontrastes wurden Resistmuster 7 Sekunden belichtet und der Kontrast zwischen belichteten und unbelichteten Bereichen mit einem Macbeth-Densitometer TE-528 (Wratten 106-Filter, Durchlicht) gemessen. Die Differenz entspricht dem Kontrast.

In der folgenden Tabelle sind die Anzahl der gehärteten Keilstufen und der Kontrast notiert:

| Probe | Lichtempfindlichkeit (gehärtete Stufen) | Kontrast in Dichte-Werten |
|---|---|---|
| A (V) | 5 | 0,13 |
| B (V) | 7 | 0,12 |
| C | 8 | 0,26 |
| D | 10 | 0,27 |
| E | 11 | 0,25 |
| F | 10 | 0,33 |

Beispiel 2

Beschichtungslösungen aus je

| | |
|---|---|
| 50 Gt | eines Copolymerisats aus Methylmethacrylat und Methacrylsäure (Säurezahl 115), |
| 50 Gt | Trimethylolpropantriacrylat, |
| 0,3 Gt | Viktoriareinblau FGA, |
| 0,3 Gt | Leukokristallviolett und |
| 0,5 Gt | 2-(p-Diethylaminophenyl)-benztriazol in |
| 800 Gt | Butanon |

wurden hergestellt und jeweils mit

A: 0,6 Gt 1-Methoxy-2-picolinium-p-toluolsulfonat,

B: 0,6 Gt 2,2'-Bis-(o-chlorphenyl)-4,4',5,5'-tetraphenyl-bisimidazol,

C: 0,3 Gt 2,2-Bis-(o-chlorphenyl)-4,4',5,5'-tetraphenyl-bisimidazol und
0,3 Gt 2-Phenyl-4,6-bis-trichlormethyl-s-triazin oder

D: 0,6 Gt 2-Phenyl-4,6-bis-trichlormethyl-s-triazin

versetzt. Die Lösungen wurden auf elektrolytisch aufgerauhtes und durch Anodisierung gehärtetes 0,3 mm starkes Aluminium durch Aufschleudern aufgetragen. Die Schichten wurden 2 Minuten bei 100 °C getrocknet, wobei man Schichtgewichte von 2,6 g/m$^2$ erhielt. Die lichtempfindlich beschichteten Platten wurden mit einer 15 %igen wäßrigen Lösung von Polyvinylalkohol (12 % Restacetylgruppen, K-Wert 4) überzogen und zu einer Deckschicht von ca. 4 g/m$^2$ getrocknet. Die so erhaltenen Druckplatten wurden mit einer 2-kW-Metallhalogenidlampe 4 Sekunden in einem Abstand von 100 cm unter einer Negativvorlage und einem Stufenkeil wie in Beispiel 1 belichtet.

Zur Bestimmung des Belichtungskontrastes wurden die Cie-L*, a*, b*-Werte einer belichteten und einer unbelichteten Fläche mit einem Spektralphotometer der Firma Pacific Scientific Co - Gardner Neotec Instrument Div. gemessen. Dabei bedeuten die L*-Werte ein Maß für den Kontrast, angegeben auf einer Skala von O (dunkel) bis 100 (hell). Zwischen den gemessenen L*-Werten wurde die Differenz gebildet. Die Werte für a* und b* geben gemeinsam ein Maß für den Farbwert der Probe an. Sie wurden bei der Beurteilung dieser Muster nicht verwertet. Die Delta-L*-Werte sind in der folgenden Tabelle zusammengefaßt. Eine höhere L*-Differenz bedeutet einen besseren Kontrast.

Die hellen, durch Licht nicht gehärteten Teile wurden durch Überwischen mit einer Entwicklerlösung folgender Zusammensetzung entfernt:

| | |
|---|---|
| 3 Gt | Natriumsilikat x 9 $H_2O$, |
| 0,05 Gt | Strontiumchlorid, |
| 0,03 Gt | nichtionogenes Netzmittel (Kokosfettalkohol-Polyoxyethylenether mit ca. 8 Oxyethyleneinheiten) und |
| 100 Gt | vollentsalztem Wasser. |

Die Anzahl der gehärteten Keilstufen ist ein Maß für die Lichtempfindlichkeit der Schichten bzw. der Druckplatten:

| Schicht | A (V) | B (V) | C | D |
|---|---|---|---|---|
| Delta L*-Wert | 2,61 | 2,38 | 5,47 | 4,76 |
| Stufen gehärtet | 2 | 4 | 7 | 7 |

Beispiel 3

Lösungen aus je

| | |
|---|---|
| 54 Gt | eines Polymeren aus 99 % Methylmethacrylat und 1 % Methacrylsäure, |
| 7,3 Gt | o/p-Toluolsulfonamid, |
| 0,4 Gt | Leukokristallviolett, |
| 38 Gt | des Esters aus 1 mol Butan-1,4-bis-glycidylether und 2 mol Acrylsäure, |
| 0,1 Gt | 2-(p-Dimethylaminophenyl)-5-chlorbenztriazol und |
| 0,2 Gt | eines löslichen Kupferphthalocyanins (C.I. Solvent Blue 70) in |
| 150 Gt | Aceton |

wurden jeweils mit

A: 0,4 Gt 2,2'-Bis-(o-chlorphenyl)-4,4',5,5'-tetraphenyl-bisimidazol,

B: 0,4 Gt 1-Methoxy-2-picolinium-p-toluolsulfonat,

C: 0,4 Gt 2-Phenyl-4,6-bis-trichlormethyl-s-triazin,

D: 0,2 Gt 2-Phenyl-4,6-bis-trichlormethyl-s-triazin und
0,2 Gt 2,2'-Bis-(o-chlorphenyl)-4,4',5,5'-tetraphenyl-bisimidazol

versetzt und nach Auflösung der Zusätze auf jeweils eine biaxial verstreckte und thermofixierte Polyethylenterephthalatfolie von 25 µm Stärke so aufgebracht, daß nach dem Trocknen bei 100 °C ein Schichtgewicht von 54 g/m$^2$ erhalten wurde. Die Trockenresistfolien wurden in einer handelsüblichen Laminiervorrichtung bei 115 °C auf eine mit einer 35 µm starken Kupferfolie kaschierte Phenoplastplatte laminiert und mittels einer 5-kW-Metallhalogenidlampe im Abstand von 110 cm zwischen Lampe und Vakuumkopierrahmen 9 Sekunden belichtet. Als Vorlage diente (a) ein Stufenkeil, (b) je eine transparente und eine optisch dichte Fläche zur Messung des Belichtungskontrasts und (c) eine Strichvorlage mit Linien und Abständen von je 50 µm Breite.

Nach der Belichtung wurde die Polyesterfolie abgezogen und die Schicht in einem Sprühentwicklungsgerät mit 1,1,1-Trichlorethan 60 Sekunden entwickelt.

Der Kontrast wurde wie oben durch Bestimmung der Delta L*-Werte vor dem Entwickeln ermittelt.

| Schicht | A (V) | B (V) | C | D |
|---|---|---|---|---|
| Kontrast: (Delta L*)<br>gehärtete Keilstufen | 9,73<br>7 | 10,18<br>8 | 19,35<br>12 | 20,65<br>13 |

Optimale Belichtungszeit zur Wiedergabe des Linienmusters (in Sekunden):

| | |
|---|---|
| A | 10 |
| B | 9 |
| C | 4 |
| D | 3 |

**Patentansprüche**

1. Photopolymerisierbares Gemisch, das als wesentliche Bestandteile
   a) ein polymeres Bindemittel,

b) eine radikalisch polymerisierbare Verbindung mit mindestens einer endständigen ethylenischen Doppelbindung und einem Siedepunkt oberhalb 100 °C bei Normaldruck und
c) eine Trichlormethylverbindung der allgemeinen Formel I

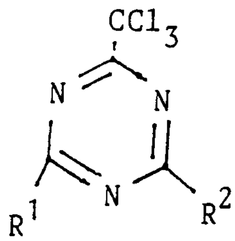

(I)

enthält, worin
$R^1$ und $R^2$ gleich oder verschieden sind und ggf. substituierte Alkyl-, Alkenyl- oder Arylreste oder Trichlormethylreste bedeuten,
dadurch gekennzeichnet, daß es als weiteren Photoinitiator eine Verbindung der allgemeinen Formel II

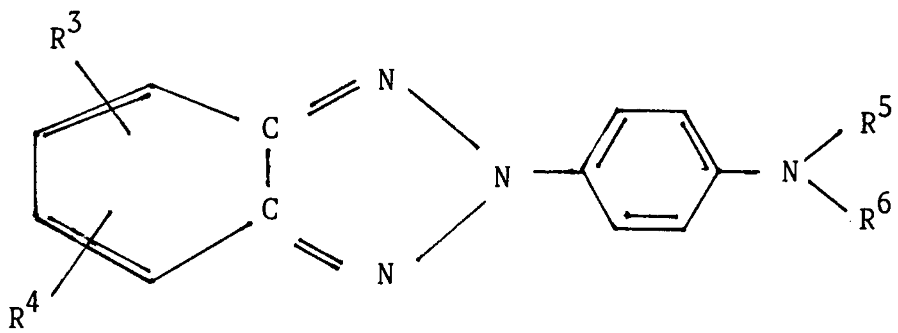

(II)

enthält, worin
$R^3$ und $R^4$ gleich oder verschieden sind und einzeln Wasserstoff- oder Halogenatome, Alkyl-, Alkoxy-, Alkoxycarbonyl- oder Arylreste oder gemeinsam einen anellierten Benzolring und
$R^5$ und $R^6$ untereinander gleiche oder verschiedene Alkyl-, Aryl- oder Aralkylreste oder gemeinsam einen fünf- oder sechsgliedrigen heterocyclischen Ring bedeuten.

**2.** Photopolymerisierbares Gemisch nach Anspruch 1, dadurch gekennzeichnet, daß es eine Verbindung der Formel I enthält, worin $R^1$ eine Alkyl-, Aryl- oder Aralkenylgruppe und $R^2$ eine Trichlormethylgruppe ist.

**3.** Photopolymerisierbares Gemisch nach Anspruch 1 oder 2, dadurch gekennzeichnet, daß es 0,05 bis 0,5 Gew.-% an Verbindungen der Formel I enthält.

**4.** Photopolymerisierbares Gemisch nach Anspruch 1, dadurch gekennzeichnet, daß es eine Verbindung der Formel II enthält, worin $R^5$ und $R^6$ Alkylgruppen mit je 1 bis 4 Kohlenstoffatomen bedeuten.

**5.** Photopolymerisierbares Gemisch nach Anspruch 1 oder 4, dadurch gekennzeichnet, daß es 0,05 bis 1 Gew.-% an Verbindungen der Formel II enthält.

**6.** Photopolymerisierbares Gemisch nach Anspruch 1, dadurch gekennzeichnet, daß es die Verbindungen der Formel I und II im Mengenverhältnis 1:10 bis 20:1 enthält.

**7.** Photopolymerisierbares Gemisch nach Anspruch 1, dadurch gekennzeichnet, daß die radikalisch polymerisierbare Verbindung ein Acryl- oder Methacrylsäureester eines mehrwertigen Alkohols ist.

**8.** Photopolymerisierbares Gemisch nach Anspruch 1, dadurch gekennzeichnet, daß es 20 bis 80 Gew.-%

an polymerem Bindemittel und 20 bis 75 Gew.-% an polymerisierbarer Verbindung enthält.

**9.** Photopolymerisierbares Aufzeichnungsmaterial mit einem Schichtträger und einer photopolymerisierbaren Schicht, dadurch gekennzeichnet, daß die Schicht aus einem Gemisch gemäß einem der Ansprüche 1 bis 8 besteht.

**10.** Photopolymerisierbares Aufzeichnungsmaterial nach Anspruch 9, dadurch gekennzeichnet, daß der Schichtträger eine von der Schicht mechanisch abtrennbare transparente flexible Kunststoffolie ist und die andere Seite der Schicht mit einem flexiblen Deckblatt abgedeckt ist, das an der Schicht weniger haftet als die Kunststoffolie.

Europäisches Patentamt

# EUROPÄISCHER RECHERCHENBERICHT

Nummer der Anmeldung

EP 91115458.1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | DE - A - 3 822 909 (FUJI PHOTO FILM CO.) * Ansprüche * -- | 1 | G 03 F 7/029<br>G 03 F 7/032<br>G 03 F 7/11 |
| D,Y | EP - A - 0 291 878 (BASF AKTIENGESELLSCHAFT) * Ansprüche * ---- | 1 | |

RECHERCHIERTE SACHGEBIETE (Int. Cl.5)

G 03 F
C 08 F

Der vorliegende Recherchenbericht wurde für alle Patentansprüche erstellt.

| Recherchenort | Abschlußdatum der Recherche | Prüfer |
|---|---|---|
| WIEN | 11-12-1991 | BECK |

KATEGORIE DER GENANNTEN DOKUMENTEN

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82